# EUROPEAN PATENT APPLICATION

(11) **EP 4 509 822 A1**
(43) Date of publication of application: **19.02.2025**
(21) Application number: 23869690.0
(22) Date of filing: 01.06.2023
(51) Int. Cl.: G01N 21/88, G01N 21/95, G01N 21/01, G02B 25/00

(54) **ARRAY-TYPE IMAGE DETECTION APPARATUS**

(30) Priority: 27.09.2022 CN 202211180946
(71) Applicant: Weihai Hualing Opto-Electronics Co., Ltd., Weihai, Shandong 264209 (CN)
(72) Inventor: QU, Tao, Weihai, Shandong 264209 (CN); QI, Wuchang, Weihai, Shandong 264209 (CN); LIU, Zhenxiang, Weihai, Shandong 264209 (CN)
(74) Representative: Ipside
(86) International application number: PCT/CN2023/097787
(87) International publication number: WO 2024/066437

(57) **Abstract**

The present application provides an array-type image detection device including two rows of imaging arrays arranged at intervals along a first direction, each row of the imaging array includes a plurality of imaging modules arranged at intervals along a second direction, each imaging module includes a magnifying lens and an imaging chip arranged in sequence along its optical axis; the image to be detected in a detection area of each imaging module is imaged in an imaging area of each imaging module in a magnified way by each imaging module and is acquired by the imaging chip in the imaging area of each imaging module; and except for the detection areas at the front and back sides in the second direction, each detection area has overlapping portions with other detection areas at two ends along the second direction. The array-type image detection device provided by the present application can effectively solve the problems of the low resolution of existing contact image sensors, difficulty in detecting high-resolution images, and detection blind spots when performing magnified detection, and can obtain a clear magnified image of the image to be detected within the range of the full surface.

## Description

### Technical Field

The present application belongs to the field of optical imaging technology, and specifically, relates to an array-type image detection device.

### Background of the Invention

Image detection technology involves multiple technical fields such as optical imaging, photoelectric conversion, and signal processing. It can be widely used in industrial production and manufacturing processes to detect product quality by acquiring detailed features such as the structure and texture of the exterior and/or interior of a product. Obviously, since the products to be inspected and the image features to be identified differ in size by multiple orders of magnitude, it is necessary to determine image detection solutions with different detection accuracy/resolution for different products to be inspected and detection scenarios. In particular, when it is necessary to detect micron-level image features, defects, and flaws on the surface of a product, it is even more necessary to design a special image detection solution.

In the manufacturing process of lithium batteries, the detection of micron-level burrs between the positive and negative electrodes and the membrane is a typical image detection scenario that requires obtaining micron-level features of the product. With the expansion of China's new energy vehicle market, the demand for power lithium batteries is increasing significantly. At the same time, the rapid development of industries such as mobile phones, electric vehicles, power tools, and digital cameras has also led to a growing demand for lithium batteries. The rapid development of the lithium battery industry has become a new investment focus in the manufacturing field. However, at the same time, various news about lithium battery fires and explosions have been reported from time to time in the media, making consumers hesitant when choosing. Through research, it is found that the micron-level burr between the positive and negative electrodes and the membrane of lithium batteries, which can only be seen clearly under a microscope, is one of the main causes of lithium battery explosions and fires. Since it is difficult to avoid burrs in the above-mentioned parts whether it is hardware die cutting or laser cutting, the comprehensive and accurate detection of the above-mentioned micron-level burrs has become a key measure to ensure the safety of lithium battery products.

It is often difficult to achieve ideal results by using existing image detection methods to perform full-surface real-time high-resolution detection of the above-mentioned micron-level image features. For example, when using CCD or COMS cameras for image acquisition, due to the large size of the equipment and the long scanning distance, it is often not suitable for installation and operation in the actual production line environment; and when using conventional contact image sensors, due to their low imaging resolution, there is a problem that high-resolution image detection cannot be accurately achieved. Therefore, there is an urgent need for a method that can effectively magnify the image of the product to be inspected to achieve accurate acquisition of high-resolution image features using low-resolution chips and can ensure close-range and full-surface image detection to meet the needs of synchronous and comprehensive detection during the production process.

### Summary of the Invention

In order to solve the above problems existing in the conventional technique, the purpose of the present application is to provide an array-type image detection device that realizes high-resolution, close-range, and full-surface image detection using a low-resolution imaging chip.

The embodiments of the present application can be implemented through the following technical solutions.

An array-type image detection device comprises two rows of imaging arrays arranged at intervals along a first direction, where each row of imaging array includes a plurality of imaging modules arranged at intervals along a second direction, and each imaging module includes a magnifying lens and an imaging chip arranged in sequence along an optical axis of each imaging module; an image to be detected in a detection area of each imaging module is imaged by each imaging module in a magnified form in an imaging area of each imaging module and acquired by the imaging chip in the imaging area of each imaging module; and except for the detection areas located at a front side and a rear side in the second direction, each of two ends of each detection area along the second direction has a portion overlapping with other detection areas.

Furthermore, the magnifying lens is a meniscus lens, a light incident surface of the magnifying lens is a concave surface, and a light exit surface of the magnifying lens is a convex surface; a radius of the light incident surface is less than or equal to 15 mm, a radius of the light exit surface is less than or equal to 8 mm, and a distance between an intersection of the light incident surface and the optical axis and an intersection of the light exit surface and the optical axis is less than or equal to 3 mm.

Preferably, the magnifying lens is cut with its optical axis as an axis center so that a projection via the magnifying lens on a plane perpendicular to the optical axis is a rectangle and the length of the rectangle is in the range of 9 to 11 mm, and a width of the rectangle is in the range of 2 to 6 mm.

Preferably, the distance from the detection area to the imaging area of each imaging module is less than or equal to 90 mm and the magnification of the image is 1 to 6 times.

Furthermore, in the two rows of imaging arrays, each imaging module in one row of imaging array has a first optical axis in the same direction, and each imaging module in the other row of imaging array has a second optical axis in the same direction, and the first optical axis and the second optical axis are both perpendicular to the second direction.

Preferably, an angle formed by the first optical axis and the second optical axis is in a range of 8° to 12°, a bisector of the angle extends along a third direction, and the third direction is perpendicular to the first direction and the second direction.

Preferably, the detection area of each imaging module is at the same height in the third direction.

Furthermore, each imaging module further includes an aperture stop located on an optical axis of each imaging module, and the aperture stop is located between the detection area and the magnifying lens of each imaging module.

Preferably, the distance from the aperture stop of each imaging module to the detection area of each imaging module is less than or equal to 25 mm.

Preferably, an imaging surface of each imaging chip is perpendicular to an optical axis of the imaging module including each imaging chip.

Preferably, the array-type image detection device also includes a hollow outer frame for fixedly accommodating each imaging module.

Preferably, the array-type image detection device further includes a light-proof partition, and the partition is located between the two rows of imaging arrays.

Preferably, the array-type image detection device also includes a light source module, and the light source module is used to generate light directed to the detection area.

Preferably, the array-type image detection device further includes: a data conversion module used to convert an analog signal acquired by each imaging chip into a digital signal; and a data processing module used to process the digital signal and generate a digitized magnified image of the image to be detected.

The array-type image detection device provided in embodiments of the present application achieves miniaturization of the device while meeting the requirements of close-range magnified imaging through the magnifying lenses provided in each imaging module and the design of the structural parameters of the magnifying lenses, thereby solving the problem of excessive installation space for the device and addressing the need to use a low-resolution imaging chip to closely scan a high-resolution object surface.

In addition, two rows of imaging arrays are arranged in a staggered manner so that each detection area overlaps with each other along the scanning direction. In addition, the optical axes of the two rows of imaging arrays are preferably at a certain angle, which effectively solves the problem of detection blind spots in a single row of imaging arrays during magnified detection, and can ensure that the full-surface scanning information of the relevant image to be detected can be read within a certain error range.

### Brief Description of the Drawings

FIG. 1 is a schematic diagram of the structure of a lithium battery membrane.
FIG. 2 is a schematic diagram of the layout of an existing array-type image detection device integrated into a production line environment.
FIG. 3 is a side cross-sectional view of an array-type image detection device along a first direction according to embodiments of the present application.
FIG. 4 is a side cross-sectional view of a row of imaging arrays of an array-type image detection device along a second direction according to embodiments of the present application.
FIG. 5a is a schematic three-dimensional diagram of a magnifying lens of an array-type image detection device according to embodiments of the present application.
FIG. 5b is a side cross-sectional view of the magnifying lens shown in FIG. 5a.
FIG. 5c is a top view of the magnifying lens shown in FIG. 5a.
FIG. 6 is a light path diagram of a magnifying lens of an array-type image detection device according to embodiments of the present application.
FIG. 7 is a top view of a plurality of first imaging areas and a plurality of second imaging areas of an array-type image detection device according to embodiments of the present application.
FIG. 8 is a top view of a plurality of first detection areas and a plurality of second detection areas corresponding to FIG. 7.
FIG. 9 is a side cross-sectional view of an array-type image detection device along a first direction according to another embodiment of the present application.

### Reference Numbers:

1: first imaging array, 10: first imaging module, 11: first magnifying lens, 11A: light incident surface, 11B: light exit surface, 12: first imaging chip, 121: first photoelectric conversion chip, 122: first chip substrate, 13: first aperture stop, 14: first optical axis, 15: first imaging area, 16: first detection area, 2: second imaging array, 20: second imaging module, 21: second magnifying lens, 22: second imaging chip, 221: second photoelectric conversion chip, 222: second chip substrate, 23: second aperture stop, 24: second optical axis, 25: second imaging area, 26: second detection area, 31: outer frame, 32: second outer frame, 33: heat sink, 34: partition, 4: light source module, 41: diffusive film, 42: light source substrate, 43: light source chip, 51: relay substrate, 52: data processing substrate, 600: socket, 601: socket, 602: data processing chip, 603: socket, 604: serial port circuit, 605: socket, 700: core material, 701: coating, 702: coating, 703: burr, 800: CIS sensor, 810: photoelectric conversion chip substrate, 811: photosensitive element, 900: object to be detected

### Detailed Description of Embodiments

Hereinafter, the present application will be further described based on preferred embodiments with reference to the accompanying drawings.

In addition, various components on the drawings are enlarged or reduced in size for ease of understanding, but this practice is not intended to limit the scope of protection of the present application.

Words importing the singular also include its plural meaning and vice versa.

In the description of the embodiments of the present application, it should be noted that if the terms "upper", "lower", "inner", "outer", etc. indicate an orientation or positional relationship based on the orientation or positional relationship shown in the accompanying drawings, or the orientation or positional relationship in which the products of the embodiments of the present application are usually placed when in use, it is only for the convenience of describing the present application and simplifying the description and does not indicate or imply that the device or element referred to must have a specific orientation, be constructed and operated in a specific orientation, and therefore cannot be understood as a limitation on the present application. In addition, in the description of the present application, in order to distinguish different units, the words first, second, etc. are used in this specification, but these are not limited by the order of manufacture, nor can they be understood as indicating or implying relative importance, and their names may be different in the detailed description and claims of the present application.

The vocabulary in this specification is used to illustrate the embodiments of the present application, but is not intended to limit the present application. It should also be noted that, unless otherwise clearly specified and limited, the terms "dispose", "connect", and "attach" should be understood in a broad sense. For example, it can be a fixed connection, a detachable connection, or an integral connection; it can be a mechanical connection, a direct connection, an indirect connection through an intermediate medium, or a connection between the two elements. For those skilled in the art, the specific meanings of the above terms in this application can be specifically understood.

In order to more clearly explain the technical solution of the present application, the technical difficulties faced in real-time detection of micron-level image features in the current production and manufacturing process are first described in detail.

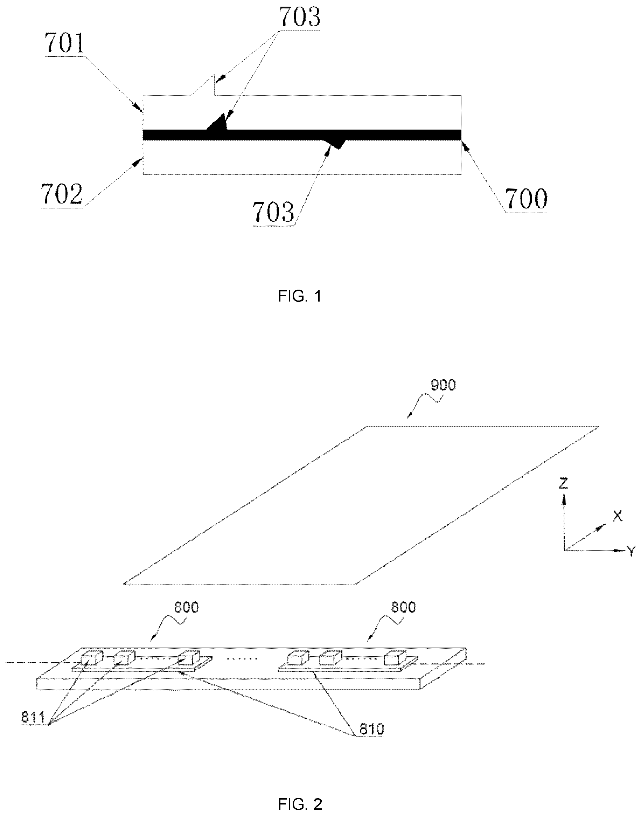

FIG. 1 shows a schematic diagram of a battery membrane structure of a lithium battery. As shown in FIG. 1, the battery membrane includes a core material 700 made of copper or aluminum and coatings 701 and 702 coated on both sides of the core material 700. Generally, the thickness of the core material 700 in combination with the coatings 701 and 702 is about tens of micrometers. During the manufacturing and cutting process of the battery membrane, various burrs 703 often appear on the surface of the core material and the coating. These burrs 703 cause slight flaws on the surface of the battery membrane and greatly increase the probability of leakage, explosion, and other dangers of the lithium battery. Therefore, in the production process of the battery membrane, it is an essential process to detect the burrs 703 on the battery membrane.

By using a microscope and other equipment to perform statistical analysis on the size of the burr 703, it can be determined that the size of the burr is generally around 20 um, and the burr 703 may appear at various positions on the battery membrane. This determines the need to achieve real-time detection of micron-level image features within a range equivalent to the entire battery membrane surface without affecting the normal operation of the production line.

An optional image detection solution is to use a linear scan camera (such as a CCD or COMS camera) to continuously scan and detect the product. However, although linear scan cameras can achieve high-resolution dynamic scanning, they are generally large in size and have a long scanning distance. They are often limited by the equipment space and cannot be installed. In addition, a scanning distance that is too long will lead to a sharp increase in the cost of hardware equipment that meets the performance indicators required to detect the above-mentioned micron-level burrs.

Another option is to use a CIS (Contact Image Sensor) or CIS array to perform close dynamic scanning of the battery membrane. CIS is a common sensor used for image acquisition/collection. CIS can convert the image's optical signal into an electrical signal through multiple photosensitive elements arranged in an array and corresponding photoelectric conversion chips. CIS, due to its small size and high integration, is particularly suitable for collecting and acquiring product images in various production line environments.

FIG. 2 shows a layout and image detection scheme of an image detection device integrated into a production line environment. As shown in FIG. 2, the surface of an object 900 to be detected has a certain width along a Y direction (usually referred to as the scanning direction). Under the normal operation of the production line, the object 900 moves continuously along an X direction (usually referred to as the scanning sub-direction). An image detection device includes a plurality of CIS sensors 800 arranged at intervals along the Y direction (usually the number of CIS sensors 800 needs to be determined according to the surface of the object 900 to be detected to form coverage of the entire surface), where each CIS sensor 800 includes a photoelectric conversion chip including an array of linearly spaced photosensitive elements 811, which is used to convert the light emitted from the surface of the object 900 to be detected into an analog signal (electrical signal). Obviously, the number of photosensitive elements 811 contained in a unit length is the resolution of the CIS sensor (with DPI as the unit of the resolution). The above-mentioned photoelectric conversion chip is generally mounted on a photoelectric conversion chip substrate 810. In addition, the CIS sensor generally includes an interface circuit for serially outputting the analog signal after photoelectric conversion.

After completing the above arrangement, different areas passing through the above image detection device can be continuously and fully scanned at certain time intervals during the continuous movement of the object 900 to be detected. For each scan, a row of photoelectrically converted image signals can be obtained through each photosensitive element 811. Multiple rows of image signals obtained in multiple scans are spliced to obtain a two-dimensional detection image of the object 900 to be detected.

The above image detection device can perform image detection on normal-size objects to be detected, but it is difficult to directly apply the above image detection device to the detection of micron-level burr images of battery membranes. The reason is that the imaging resolution of conventional contact image sensors is low. Taking a CIS sensor with a resolution of 1200DPI as an example, its pixel size is 25.4 mm/1200 ≈ 21 um, that is, the minimum resolution of its imaging surface is 21 um. Obviously, for burrs of about 20um, it is impossible to clearly image and identify them using the contact image sensor of the above specifications alone, and the structure of the contact image sensor needs to be improved to meet the requirements of high-resolution image recognition.

However, simply using a single magnifying lens cannot simultaneously meet the requirements of clear imaging covering the entire detection surface and close contact detection. Therefore, it is necessary to combine the actual production line environment and the characteristics of the selected image sensor to reasonably design the optical path of the image magnification part and its coordination with the imaging part, so as to achieve close full-surface detection of micron-level image features.

To achieve the above-mentioned purpose, the present application provides an array-type image detection device through embodiments. The array-type image detection device includes two rows of imaging arrays arranged at intervals along a first direction, each row of imaging array includes a plurality of imaging modules arranged at intervals along a second direction, each imaging module includes, along its optical axis, a magnifying lens and an imaging chip arranged in sequence; each imaging module images an image to be detected in its detection area in a magnified way in its imaging area to be acquired by an imaging chip within its imaging area; and except for the detection areas located at a front side and a rear side in the second direction, each detection area has an overlapping part with another detection area at both ends along the second direction.

The array-type image detection device provided by embodiments of the present application is provided with two rows of imaging arrays arranged at predetermined intervals in the first direction, where each row of the imaging array includes a plurality of modules for magnified imaging arranged at intervals along the second direction, and each detection area of the above two rows of imaging arrays is arranged to overlap each other along the second direction. The arrangement of the above two rows of imaging arrays arranged at intervals in a staggered way can enable the multiple detection areas to form a full-width coverage in the second direction, thereby ensuring that the images within the coverage range of the above multiple detection areas can be clearly magnified and imaged without omission.

The array-type image detection device provided by the present application is described in detail below through specific embodiments.

### [ Example 1]

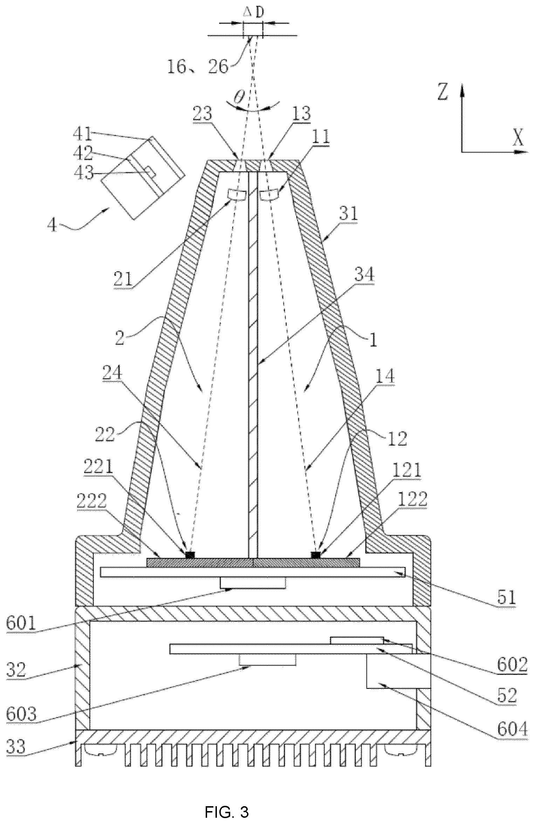

FIG. 3 shows a side cross-sectional view along an X-axis direction of an array-type image detection device according to a preferred embodiment 1 of the present application. As shown in FIG. 3, the array-type image detection device includes a first imaging array 1 and a second imaging array 2 arranged at a predetermined interval along a first direction (represented by the X-axis in FIG. 3).

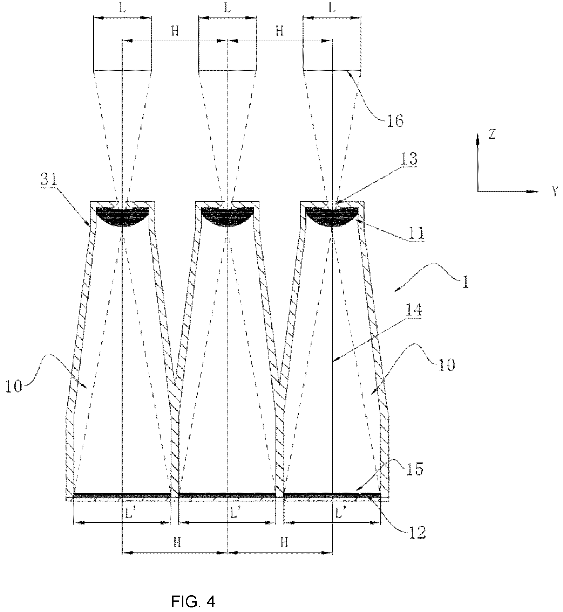

FIG. 4 further shows a side cross-sectional view of the first imaging array 1 along the second direction (indicated by a Y-axis in FIG. 4, the Y axis is different from the X-axis direction, where preferably, the Y axis is perpendicular to the X axis). As shown in FIGS. 3 and 4, the first imaging array 1 includes a plurality of first imaging modules 10 arranged at intervals of length H along the Y-axis direction. The Y-axis direction is generally referred to as the scanning direction. Obviously, the number of first imaging modules 10 can be determined based on the length that each imaging module 10 can effectively detect along the scanning direction and the whole length that needs to be detected in the scanning direction, so as to ensure coverage of the entire surface to be detected. It should be noted that the interval H between the first imaging modules 10 in the figure is only a schematic preferred arrangement, but does not constitute a limitation to the present application.

Furthermore, the array-type image detection device further includes a hollow outer frame 31 for fixedly accommodating the above-mentioned imaging modules. The outer frame 31 can be made of metal aluminum material to further increase the stability of the structure. The above-mentioned imaging modules are fixed inside the outer frame 31 according to their respective optical path parameters by bonding, plugging-in, etc., and the inner wall of the outer frame 31 is coated with a black oxide coating, which can effectively eliminate the influence of stray light on image detection.

In this embodiment, preferably, as shown in FIG. 3, the array-type image detection device further includes a light source module 4, the light emitted by the light source module 4 is directed to the area to be detected, so as to increase the light emitted by the surface of the object in the area to be detected, thereby facilitating subsequent image detection. The light source module 4 is a linear light source, and its effective light emitting area extends along the Y-axis direction and covers the entire surface to be detected. Furthermore, a light source chip 43 is mounted on a light source substrate 42.

Preferably, as shown in FIG. 3, the light source substrate 42 is made of aluminum to increase the heat dissipation effect, and a diffuser film 41 is provided to achieve a uniform light effect. To further increase the lighting effect, the number of light source modules 4 can also be two or more, and the method of lighting with light sources on two sides is adopted.

In this embodiment, preferably, the array-type image detection device also includes a data conversion module to realize the conversion of analog signals acquired by the imaging chips in each imaging module into digital signals. Specifically, as shown in FIG. 3, the data conversion module includes a relay substrate 51, and a circuit for data transmission and conversion (not shown in the figure) mounted on the relay substrate 51. The data transmission between the relay substrate 51 and each imaging chip is realized through a corresponding signal interface, that is, a soldering pad of the relay substrate 51 and a back soldering pad of the imaging chip are welded together through a process such as pin insertion or reflow soldering, thereby realizing data transmission.

In this embodiment, preferably, the array-type image detection device further includes a data processing module. Specifically, as shown in FIG. 3, the data processing module includes a data processing substrate 52, on which a data processing chip 602 and a serial port circuit 604 are mounted. The data processing chip 602 has an image preprocessing function for processing the digital signal received from the data conversion module to synthesize the detection image, and sending it to the external display module PC terminal through the serial port circuit 604 to complete the display of the entire image. Those skilled in the art can select a suitable data chip and serial port circuit substrate according to specific needs, such as selecting an FPGA chip and a CAMRALINK serial port circuit substrate, or other optional data chips and serial port circuits.

In addition, the data processing chip 602 also controls the timing cycle by setting the internal register to realize the control of the light source module 4, so as to achieve the purpose of synchronizing the light emission frequency of the light source module 4 and the scanning frame rate of each imaging module within the scanning cycle.

Preferably, as shown in FIG. 3, the array-type image detection device further includes a second outer frame 32, the data conversion module is fixedly accommodated inside the outer frame 31, the data processing module is fixedly accommodated inside the second outer frame 32, and the second outer frame 32 is fixedly connected to the outer frame 31 by plugging-in, bonding, integral molding or any other suitable method. The digital signal output by the data conversion module is connected through the connection between socket 601 and socket 603 of the data processing module to realize signal conversion and transmission.

Preferably, a heat sink 33 is further provided on a side of the second outer frame 32 facing away from the outer frame 31. The heat sink 33 is preferably made of metal or other materials with excellent heat dissipation performance to dissipate heat generated by the data processing chip 602 during operation.

The overall structure of the array-type image detection device of this embodiment is introduced above. Next, the working principle of the array-type image detection device is described in detail.

Still taking the first imaging array 1 as an example, as shown in FIG. 3 and FIG. 4, each first imaging module 10 in the first imaging array 1 includes a first magnifying lens 11 and a first imaging chip 12 sequentially arranged along its optical axis (represented by a first optical axis 14).

Furthermore, due to the magnifying effect of the first magnifying lens 11, each first imaging module 10 has a first detection area 16 and a first imaging area 15 on two sides of the first magnifying lens 11, where the image to be detected located in the first detection area 16 can be imaged in the first imaging area 15 in a magnified form and acquired by the first imaging chip 12 located in the first imaging area 15.

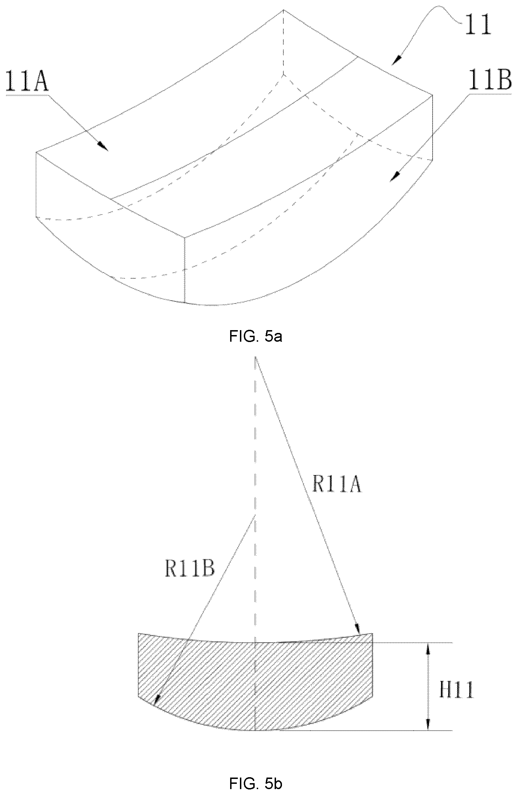

FIGS. 5a to 5c respectively show a stereoscopic view, a side cross-sectional view, and a top view of the first magnifying lens 11 included in the first imaging module 10 in some preferred embodiments. As shown in FIG. 5a, preferably, the first magnifying lens 11 is made of a meniscus lens, where a surface of the meniscus lens that faces the object is a light incident surface 11A, which is a concave surface having a certain convergence effect on the light, and a surface of the meniscus lens that faces the image is a light exiting surface 11B, which is a convex surface having a certain divergence effect on the light.

Those skilled in the art already know that by designing the radius of the light incident surface, the radius of the light exit surface, and the spacing between the light incident surface and the light exit surface, the object distance, the image distance, and the magnification of the lens can be determined. In the present embodiment, preferably, as shown in FIG. 5b, the radius R11A of the light incident surface 11A is less than or equal to 15mm, the radius R11B of the light exit surface 11B is less than or equal to 8mm, and the distance H11 between the intersection of the light incident surface 11A and the first optical axis 14 and the intersection of the light exit surface 11B and the first optical axis 14 is less than or equal to 3mm. By setting the above-mentioned preferred structural parameters, the image to be detected can be magnified by 1 to 6 times under the condition that the distance between the first detection area 16 and the first imaging area 15 is less than or equal to 90mm, thereby realizing the magnified detection of the image to be detected on the basis of satisfying the miniaturization of the equipment.

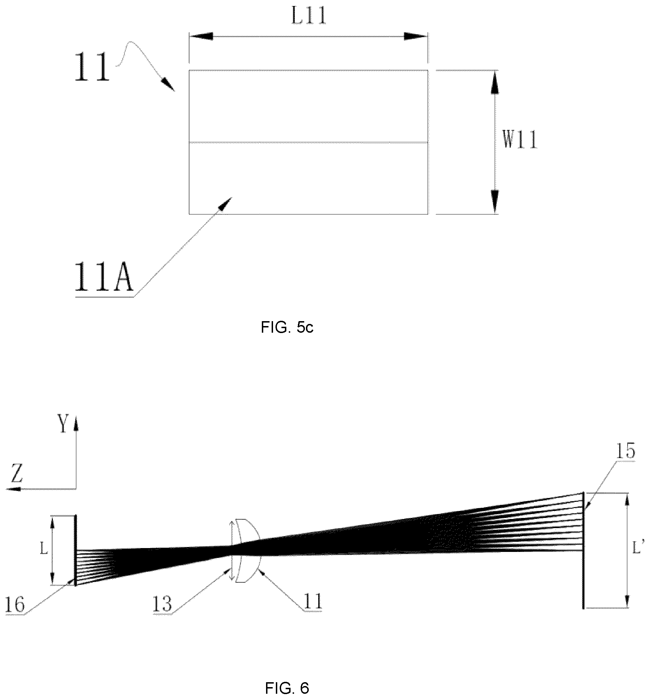

In this embodiment, preferably, the first magnifying lens 11 is made of glass or other materials with good optical properties and high processing properties. Furthermore, the lens adopts coating and other processes to reduce the reflected light on the lens surface and increase the light transmittance. In addition, to facilitate the installation of the lens and realize the miniaturization of the device, as shown in FIGS. 5a and 5c, the lens can be cut into strips with the optical axis as the center. Preferably, after the first magnifying lens 11 is cut, the length of the first magnifying lens 11 along the Y-axis direction is 9 mm to 11 mm, and the width of the first magnifying lens 11 along the X-axis direction is 2 mm to 6 mm.

In this embodiment, optionally, the first imaging chip 12 included in the first imaging module 10 is the linear CIS sensor described above. Specifically, the first imaging chip 12 includes a first chip substrate 122, and a first photoelectric conversion chip 121 and corresponding connecting wires and interface circuits (not shown in the figure) are mounted on the first chip substrate 122. In addition, in some other embodiments, other sensors with image scanning functions can also be selected according to actual image detection needs.

In this embodiment, as shown in FIG. 3, the first imaging module 10 preferably further includes a first aperture stop 13 provided along the first optical axis 14, and the first magnifying lens 11 is located between the first aperture stop 13 and the first imaging chip 12. The first aperture stop 13 can be used to block light rays that are relatively deviated from the first optical axis 14 in the light beam, which has a direct impact on the clarity, correctness, brightness, and depth of field of the imaging. The first aperture stop 13 has a circular hole structure with an aperture of 1.4 mm to 1.6 mm, which can be made by digging a hole in the middle of the light-shielding paper or can be directly processed by digging a hole at the intersection of the outer frame 31 and the first optical axis 14.

Preferably, the working distance from the first aperture stop 13 to the first detection area 15 is less than or equal to 25 mm, which can achieve the effect of close-range scanning and imaging, is conducive to the miniaturization of the equipment, and solves the problem of equipment installation space.

FIG. 6 further shows a half-field optical path diagram of the first imaging module 10. As shown in FIG. 6, based on the specific requirements of close-range magnified imaging, by designing the size parameters of the first magnifying lens 11, which includes the radius of the light entrance surface, the radius of the light exit surface, and the distance between the intersection of the light entrance surface and the first optical axis and the intersection of the light exit surface and the first optical axis, the magnification of the first magnifying lens 11 and the object distance and the image distance of clear imaging can be determined. In addition, the first aperture stop 13 and the outer frame are used to limit the light deviating from the first optical axis 14. As a result, the first detection area 16 and the first imaging area 15 capable of magnifying and imaging the image to be detected located in the first detection area 16 are formed on two sides of the first optical axis 14, respectively. The lengths of the first imaging area 15 and the first detection area 16 along the Y-axis direction are L' and L, respectively, and L'/L is the magnification of the first magnifying lens 11.

It should be noted that, as shown in FIG. 6, the magnified image to be detected is an inverted real image, and in the subsequent image processing process, a signal inversion operation and the like are required.

In the actual image detection process, the object 900 to be detected (such as the battery membrane described above) is placed in the first detection area 16, and the first imaging chip 12 is placed in the first imaging area 15. Generally, since the first imaging module 10 realizes image acquisition through the first imaging chip 12, the effective scanning length of the first imaging chip 12 can be considered to be equal to L'. At this time, the image of the surface of the object to be detected (the image to be detected) can be magnified and clearly imaged in the first imaging area 15 and acquired by the first imaging chip 12.

Table 1 below schematically shows a set of preferred design parameters of the first imaging module 10. Obviously, those skilled in the art can also determine corresponding design parameters according to actual image detection indicators.

**Table 1 Preferred design parameters of the first imaging module**

| Parameters | Optimal value |
|---|---|
| Magnification of First Magnifying Lens | 1.67 |
| Distance from First Aperture Stop to First Detection Area | 25 mm |
| Length L' of First Detection Area | 18.3 mm |
| Length L of First Imaging Area | 11 mm |
| Resolution of First Imaging Chip | 1200 DPI |
| Resolution of Image to be Detected | 2000 DPI |

The structure and the magnified imaging principle of the first imaging module 10 are described in detail above. Furthermore, a plurality of first imaging modules 10 are arranged at intervals along the Y-axis direction at a spacing H, so as to form a first imaging array 1.

The above first imaging array 1 uses a plurality of magnifying lenses arranged at intervals and imaging chips corresponding to the magnifying lenses, which, under the premise of ensuring a specific magnification and scanning a wide surface, can effectively shorten the distance between the object and the image and realize close-range scanning and miniaturization of the device, thereby effectively solving the problem that, when a single magnifying lens is used, the size of the device is greatly increased since the distance between the object and the image must be increased in order to cover a larger image detection area and avoid imaging distortion. However, when a single imaging array is used, the problem of missing detection of a specific area in the entire surface to be detected still exists, and the reason can be explained by FIG. 4.

As shown in FIG. 4, in the multiple first imaging modules 10 of the first imaging array 1, since each first imaging area 15 magnifies the first detection area 16 along the Y direction, even if the first imaging chips 12 are connected to each other as closely as possible so that the first imaging areas 15 are connected end to end, there are still multiple detection blind areas in the corresponding first detection areas 16 along the Y direction, where the length of each detection blind area is H minus L. The existence of the above-mentioned detection blind areas is determined by the characteristics of the structure of multiple magnifying optical paths arranged at intervals, which leads to the phenomenon of missed detection of the surface of the object to be detected. Therefore, it is necessary to further improve the single-row magnified imaging method.

To this end, as shown in FIG. 3, in this embodiment, in addition to the first imaging array 1, a second imaging array 2 is provided which is spaced apart from the first imaging array 1 along the X-axis direction. Specifically, the second imaging array 2 includes a plurality of second imaging modules 20 spaced apart along the Y-axis direction, where each second imaging module 20 includes a second magnifying lens 21 and a second imaging chip 22 sequentially arranged along its optical axis (represented by a second optical axis 24). Accordingly, a second detection area 26 and a second imaging area 25 for magnified imaging are formed on two sides of the second optical axis 24, respectively, and the second imaging chip 22 is placed in the second imaging area 25.

Similar to the first imaging module 10, the second imaging module 20 may also include a second aperture stop 23, and the second imaging chip 22 includes a second chip substrate 222 and a second photoelectric conversion chip 221 mounted on the second chip substrate 222.

In some preferred embodiments, the structural parameters of each first imaging module 10 included in the first imaging array 1 and each second imaging module 20 included in the second imaging array 2 are the same, that is, exactly the same imaging modules can be used, and the spacing between each second imaging module 20 along the Y-axis direction is the same as the spacing between each first imaging module 10 along the Y-axis direction (both are represented by H). Therefore, FIG. 4 can also be used to explain the structure of the second imaging array 2, and for the sake of brevity, it will not be repeated here.

In this embodiment, preferably, as shown in FIG. 3, each first detection area 16 and each second detection area 26 are at the same height in a Z-axis direction, where the Z-axis is perpendicular to the X-axis and the Y-axis.

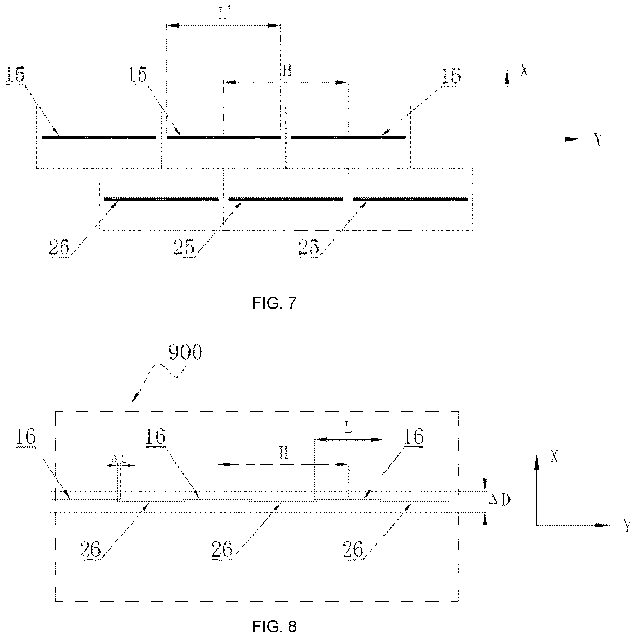

FIG. 7 shows a top view of a plurality of first imaging areas 15 and a plurality of second imaging areas 25 in the preferred embodiment. The figure schematically shows three first imaging areas 15 and three second imaging areas 25, where each first imaging chip 12 and each second imaging chip 22 are located in each of the above imaging areas. FIG. 8 shows a top view of a plurality of first detection areas 16 and a plurality of second detection area 26 corresponding to FIG. 7. In combination with FIG. 3, FIG. 4, FIG. 7, and FIG. 8, in the preferred embodiment of the present application, the first imaging modules 10 and the second imaging modules 20 are arranged in a staggered manner along the Y-axis direction, and the arrangement is designed to meet the following requirements: except for the first detection area 16 and/or the second detection area 26 located at the front and rear sides of the Y-axis direction, each of two ends of each first detection area 16 has a portion overlapping with the second detection area 26 along the Y-axis direction, and each of two ends of each second detection area 26 has a portion overlapping with the first detection area 16 along the Y-axis direction. Through the above arrangement, the first imaging array 1 and the second imaging array 2 achieve coverage of the entire area to be detected without blind spots, thereby achieving full-surface magnified detection of micron-level image features.

In this embodiment, preferably, as shown in FIG. 7, the center of each first imaging area 15 is exactly aligned with the midpoint of a line connecting the centers of two adjacent second imaging areas 25. Correspondingly, as shown in FIG. 8, the center of each first detection area 16 is exactly aligned with the midpoint of a line connecting the centers of two adjacent second detection areas 26. Two ends of each first detection area 16 have overlapping parts ΔZ with two adjacent second detection areas 26, and the same is true for the second imaging area 25 and the second detection area 26, which will not be repeated here.

Specifically, taking the parameters listed in Table 1 as an example, for the design parameters of the first imaging module 10 and the second imaging module 20, H is preferably designed to be 21 mm, so that ΔZ is equal to 0.5 mm.

It should be noted that those skilled in the art can flexibly adjust the spacing, staggered arrangement, size of overlapping portions, etc. of each imaging module in the first imaging array 1 and the second imaging array 2 to meet the needs of actual image detection, and the above adjustments do not deviate from the technical ideas of the present application.

As shown in FIG. 3, preferably, the first optical axes 14 of all first imaging module 10 are in the same direction, the second optical axes 24 of all second imaging module 20 are in the same direction, the first optical axis 14 and the second optical axis 24 are both perpendicular to the Y-axis direction, and the bisector of the angle *θ* between the first optical axis 14 and the second optical axis 24 points to the Z-axis direction.

In this embodiment, a preferred value range of *θ* is between 8° and 12°. As shown in FIGS. 3 and 8, when the depth of field of each magnifying lens is *ΔI*, according to the sine theorem, the effective width of each detection area in the scanning sub-direction, i.e., the X direction, is: *ΔD*=4*ΔI**sin(*θ*/2). The effective width represents the allowable tolerance range *ΔD* of the detection area in the X direction. That is to say, in this tolerance range of the depth of field, a clear scanned image can be obtained. Within the above range *ΔD,* the object to be detected moves continuously along the X direction and is scanned continuously. The light signal on the surface of the object is acquired by the first imaging array 1 and the second imaging array 2 and converted into an electrical signal, and then converted into an analog-to-digital signal by the data conversion module, and finally synthesized into an image of the surface by the data processing module. Specifically, the processing of the data processing module includes signal inversion, position calibration, overlap removal, image stitching, correction synthesis, etc. The above operations are known to those skilled in the art.

When the first imaging array 1 and the second imaging array 2 are close in the X direction, the optical paths of their imaging modules may affect each other. This is because when the light enters the magnifying lens on one side, although the light will normally hit the respective imaging chips, the light will be emitted divergently at a certain angle because the light exit surface of the magnifying lens is a convex structure. In addition, the distance between the imaging chips on two sides is small, so the light on one side will enter the imaging chip on the other side, causing interference.

To this end, preferably, as shown in FIG. 3, the array-type image detection device further includes a partition 34. In this embodiment, the partition 34 is located between the first imaging array 1 and the second imaging array 2, parallel to the Z axis and extending along the Y axis, and is fixedly connected to the outer frame 31 by plugging, bonding, etc. , so as to play the role of separating the magnifying lenses and the imaging chips on two sides. The partition 34 is preferably made of black PC material or other materials that are easier to absorb light, so as to absorb stray light caused by wall reflection, further increase the effective light signal, and present a clearer image.

### [Example 2]

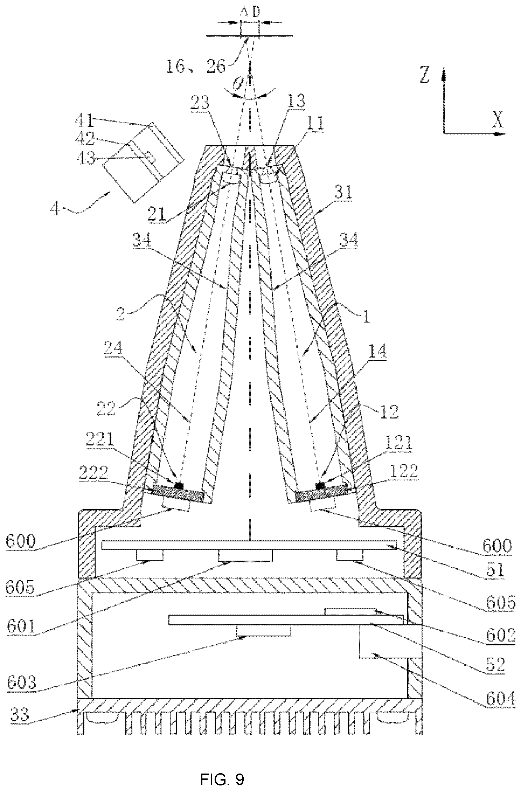

FIG. 9 shows a side cross-sectional view along the X-axis direction of the array-type image detection device according to the preferred example 2 of the present application. The difference between this example and example 1 is that the first imaging chip 12 and the second imaging chip 22 are rotated accordingly relative to the first optical axis 14 and the second optical axis 24, respectively, so that the imaging surface of each imaging chip is set to be perpendicular to the optical axis of the imaging module including the imaging chip.

Specifically, as shown in FIG. 9, the first chip substrate 122 is rotated so that its surface is perpendicular to the first optical axis 14, and the first optical axis 14 is aligned with the center of the first photoelectric conversion chip 121, so that the imaging surface of the first imaging chip 12 can be perpendicular to the first optical axis 14, and the main light beam can exactly pass through the center of the first magnifying lens 11 and hit the center of the first photoelectric conversion chip 121, which is more conducive to achieving light symmetry and can allow a larger range of scanning deviations.

The same operations can be performed on the second imaging chip 22, which will not be described in detail here.

In this embodiment, as shown in FIG. 9, after the first photoelectric conversion chip 121 and the second photoelectric conversion chip 221 convert the optical signal of the image to be detected into an analog signal, by connecting the sockets 600 provided on the first chip substrate 122 and the second chip substrate 222 to the corresponding sockets 605 provided on the relay substrate 51, respectively, so as to realize the transmission of data between the imaging chip and the data conversion module. The sockets can be connected via an FFC cable, etc.

The above is a detailed introduction to the specific implementations of the present application. For those skilled in the art, several improvements and modifications may be made to the present application without departing from the principles of the present application. These improvements and modifications also fall within the scope of protection of the claims of the present application.

## Claims

1. An array-type image detection device comprising two rows of imaging arrays arranged at intervals along a first direction, **characterized in that**:
each row of imaging array includes a plurality of imaging modules arranged at intervals along a second direction, and each imaging module includes a magnifying lens and an imaging chip arranged in sequence along an optical axis of said each imaging module;
an image to be detected in a detection area of each imaging module is imaged by said each imaging module in a magnified form in an imaging area of said each imaging module and acquired by the imaging chip in the imaging area of said each imaging module; and
except for the detection areas located at a front side and a rear side in the second direction, each of two ends of each detection area along the second direction has a portion overlapping with other detection areas.

2. The array-type image detection device according to claim 1, **characterized in that**:
the magnifying lens is a meniscus lens, a light incident surface of the magnifying lens is a concave surface, and a light exit surface of the magnifying lens is a convex surface;
a radius of the light incident surface is less than or equal to 15 mm, a radius of the light exit surface is less than or equal to 8 mm; and
a distance between an intersection of the light incident surface and the optical axis and an intersection of the light exit surface and the optical axis is less than or equal to 3 mm.

3. The array-type image detection device according to claim 1, **characterized in that**:
the magnifying lens is cut with its optical axis as an axis center so that a projection via the magnifying lens on a plane perpendicular to the optical axis is a rectangle, and a length of the rectangle is in a range of 9 to 11 mm, and a width of the rectangle is in a range of 2 to 6 mm.

4. The array-type image detection device according to claim 1, **characterized in that**:
a distance from the detection area to the imaging area of each imaging module is less than or equal to 90 mm and a magnification of the image is 1 to 6 times.

5. The array-type image detection device according to claim 1, **characterized in that**:
in the two rows of imaging arrays, each imaging module in one row of imaging array has a first optical axis in a same direction, and each imaging module in the other row of imaging array has a second optical axis in a same direction, and the first optical axis and the second optical axis are both perpendicular to the second direction.

6. The array-type image detection device according to claim 5, **characterized in that**:
an angle formed by the first optical axis and the second optical axis is in a range of 8° to 12°, a bisector of the angle extends along a third direction, and the third direction is perpendicular to the first direction and the second direction.

7. The array-type image detection device according to claim 6, **characterized in that**:
the detection area of each imaging module is at a same height in the third direction.

8. **The** array-type image detection device according to claim 1, **characterized in that**:
each imaging module further includes an aperture stop located on an optical axis of said each imaging module, and the aperture stop is located between the detection area and the magnifying lens of said each imaging module.

9. **The** array-type image detection device according to claim 8, **characterized in that**:
a distance from the aperture stop of each imaging module to the detection area of said each imaging module is less than or equal to 25 mm.

10. **The** array-type image detection device according to claim 1, **characterized in that**:
an imaging surface of each imaging chip is perpendicular to an optical axis of the imaging module including said each imaging chip.

11. **The** array-type image detection device according to claim 1, **characterized in that**:
the array-type image detection device also includes a hollow outer frame for fixedly accommodating each imaging module.

12. **The** array-type image detection device according to claim 1, **characterized in that**:
the array-type image detection device further includes a light-proof partition, and the partition is located between the two rows of imaging arrays.

13. **The** array-type image detection device according to claim 1, **characterized in that**:
the array-type image detection device also includes a light source module, and the light source module is used to generate light directed to the detection area.

14. **The** array-type image detection device according to claim 1, **characterized in that**: the array-type image detection device further includes:
a data conversion module used to convert an analog signal acquired by each imaging chip into a digital signal; and
a data processing module used to process the digital signal and generate a digitized magnified image of the image to be detected.
